# FASCICULE DE BREVET EUROPEEN

(11) **EP 3 635 832 B1**
(45) Date de publication et mention de la délivrance du brevet: **05.06.2024**
(21) Numéro de dépôt: 18736992.1
(22) Date de dépôt: 07.06.2018
(51) Int. Cl.: H02H 3/33

(54) **DISPOSITIF DE PROTECTION DIFFERENTIELLE POUR LA DETECTION D'UN COURANT DE DEFAUT**
DIFFERENZIALSCHUTZVORRICHTUNG ZUR ERKENNUNG EINES FEHLERSTROMS
DIFFERENTIAL PROTECTION DEVICE FOR DETECTING A FAULT CURRENT

(30) Priorité: 08.06.2017 FR 1755131
(43) Date de publication de la demande: 15.04.2020
(73) Titulaire: Hager-Electro SAS, 67210 Obernai (FR)
(72) Inventeur: JOYEUX, Patrice, 67140 Heiligenstein (FR); DOLISY, Bastien, 67210 Obernai (FR)
(74) Mandataire: Cabinet Nuss
(86) Numéro de dépôt international: PCT/FR2018/051323
(87) Numéro de publication internationale: WO 2018/224783

(56) Documents cités:
- WO-A2-2017/072442
- DE-A1-102011 011 983
- FR-A1- 2 993 058
- US-B1- 6 747 856

## Description

La présente invention concerne les équipements et systèmes de sécurité des biens et des personnes dans le domaine électrique, plus particulièrement les dispositifs de protection de personnes à courant différentiel résiduel (ou DDR), et a pour objet un dispositif de protection différentiel intégrant une fonction coupe-feu.

Ce type de dispositif de protection est couramment intégré dans des installations électriques domestiques ou tertiaires, en amont ou à l'entrée des diverses arborescences des circuits d'alimentation en place, voir au plus près des récepteurs auxquels ils sont respectivement affectés.

Typiquement, ces installations électriques sont alimentées par un réseau électrique alternatif, et des dispositifs de protection du type précité ont pour but d'assurer principalement la sécurité des personnes en détectant le plus rapidement possible toute fuite éventuelle vers la terre dans un des circuits ou récepteurs à protéger. De telles fuites sont par exemple causées par des contacts directs de sujets avec un conducteur non isolé ou des contacts indirects dus à des défauts de masse. Ces incidents électriques sont susceptibles de générer des accidents, parfois mortels, des détériorations de matériel(s), des départs d'incendie, des dysfonctionnements localisés ou généralisés ou analogues.

La protection différentielle, dans le contexte précité, s'effectue dans la plupart des cas d'une manière assez standardisée : au moins l'un des ou tous les conducteurs du circuit à protéger, ou l'un des ou les conducteurs de la ligne d'alimentation de ce circuit, passe(nt) dans un tore de matériau ferromagnétique d'un transformateur dont le(s) conducteur(s) précité(s) forme(nt) le primaire et qui comporte un ou plusieurs enroulement(s) ou bobinage(s) secondaire(s). Le tore joue le rôle d'un concentrateur de flux magnétique. Ainsi en cas de fuite, se traduisant par un déséquilibre des courants d'entrée et de sortie dans les conducteurs des lignes à protéger, le flux créé dans le tore par ce déséquilibre au niveau du primaire, induit dans le bobinage secondaire une tension, utilisée pour commander directement, ou à travers une électronique dédiée (étages de traitement des signaux), un actionneur (par exemple de type relais). Ce dernier actionne à son tour un mécanisme de déclenchement, de coupure ou d'ouverture associé, ou ceux d'autres appareils de protection de l'installation.

Ces appareils ou dispositifs électriques de protection différentielle peuvent présenter des caractéristiques variables. Ainsi, ils sont mutuellement différentiables et caractérisés par leur sensibilité propre, qui dépend notamment du type d'installation électrique dans laquelle ils sont utilisés et qu'ils sont destinés à protéger. Par ailleurs, certains de ces appareils ne sont capables de détecter des fuites que pour des courants alternatifs (type AC) alors que d'autres, plus complets, offrent des solutions également applicables au courant continu pulsé (types A et F) ou lissé (type B).

Un dispositif du type B est par exemple décrit dans la demande de brevet français n° 2 993 058 au nom de la demanderesse.

Par ailleurs, pour les dispositifs ayant la capacité de détecter des courants de défaut alternatifs, la fréquence limite supérieure de détection constitue un autre critère de distinction entre les différents types : fréquences jusqu'à 1kHz : type F ; fréquences jusqu'à 2kHz : type B ; fréquences jusqu'à 20kHz : type B+.

En particulier, le type B+ est, par rapport aux autres types, spécifiquement sensible aux fréquences de courant de défaut ou de fuite propices aux départs de feu.

Actuellement, les solutions existantes pour atteindre le gabarit fréquentiel requis pour un classement de type B+ sont principalement de deux types :
- mise en oeuvre d'un ensemble électronique actif réalisant des corrections adaptées de la bande passante de la courbe de sensibilité à la fréquence du courant de défaut. Un défaut d'alimentation de l'ensemble électronique transforme ce dispositif de type B+ en un dispositif de type A/AC seulement (les fonctionnalités liées au type F ou au type B ne sont plus remplies).
- mise en oeuvre d'un relais électronique pour inhiber la protection de type A/AC et son remplacement par un moyen actif réalisant la fonction AC, A, F et B.

Dans les deux solutions précitées, du type B+, on aboutit à une construction complexe, coûteuse et encombrante fondée sur la mise en oeuvre de deux circuits indépendants en parallèle ou en concurrence, la fonction coupe-feu étant inopérante en cas d'absence d'alimentation secteur.

Par le document EP 1 201 015, on connaît un dispositif de protection contre les courants de défaut avec un transformateur de courant cumulé et un circuit de déclenchement relié à un unique enroulement secondaire dudit transformateur. Ce circuit de déclenchement comprend un montage de déclenchement avec un circuit RC relié en parallèle sur son entrée connectée à l'enroulement secondaire. Ce circuit RC est dimensionné de telle manière que la valeur du courant de défaut de déclenchement est située en dessous de deux courbes limites définies réglementairement. Ces deux courbes comprennent, d'une part, une première courbe limite prédéterminée pour des fibrillations ventriculaires selon la norme IEC479 et, d'autre part, une seconde courbe limite prédéterminée associée à la protection contre le feu. Voir aussi le document équivalent US 6 747 856 B1.

Le dispositif selon le document EP précité assure une telle protection contre le feu jusqu'à des fréquences de 20 kHz seulement. En effet, à partir de 10 kHz environ, des pertes supplémentaires surviennent dans le noyau (généralement un tore) qui dégradent la tension au secondaire.

Or, il existe actuellement une demande pour disposer d'une protection contre le feu au-delà de 20 kHz et jusqu'à environ 100 kHz au moins.

Ainsi, le but premier de l'invention est de proposer un dispositif de protection différentielle du type évoqué en introduction et réalisant une fonction de protection contre le feu pour des fréquences élevées du courant de défaut, avantageusement situées au-delà de 20 kHz, ce tout en présentant une construction simple, de nature électromécanique (c'est-à-dire de type « voltage independent » : indépendant de la tension), peu coûteuse et d'encombrement réduit.

A cet effet, l'invention a pour objet un dispositif de protection différentielle présentant les caractéristiques de la revendication. 1.

L'invention sera mieux comprise, grâce à la description ci-après, qui se rapporte à des modes de réalisation préférés, donnés à titre d'exemples non limitatifs, et expliqués avec référence aux dessins schématiques annexés, dans lesquels :
la figure 1 est une représentation symbolique d'un dispositif de protection différentielle selon un mode de réalisation de l'invention ;
la figure 2 est une représentation schématique d'une variante de réalisation du dispositif représenté figure 1 ;
la figure 3 est une représentation schématique d'un dispositif de protection différentielle selon un autre mode de réalisation de l'invention ;
les figures 4 à 8 sont des courbes de sensibilité en termes de valeurs seuil de déclenchement de courant de fuite (figures B) et des courbes d'impédance équivalente (figures A) du circuit passif mis en oeuvre dans l'un quelconque des dispositifs des figures 1 à 3, ce en fonction de la fréquence desdits courants, et à chaque fois pour une réalisation spécifique dudit circuit passif (en insertion dans les figures 4A, 5A, 6A, 7A et 8A respectivement), en accord avec des variantes constructives de l'invention,
la figure 9 est une représentation schématique d'un arrangement possible de dispositifs différentiels selon l'invention.

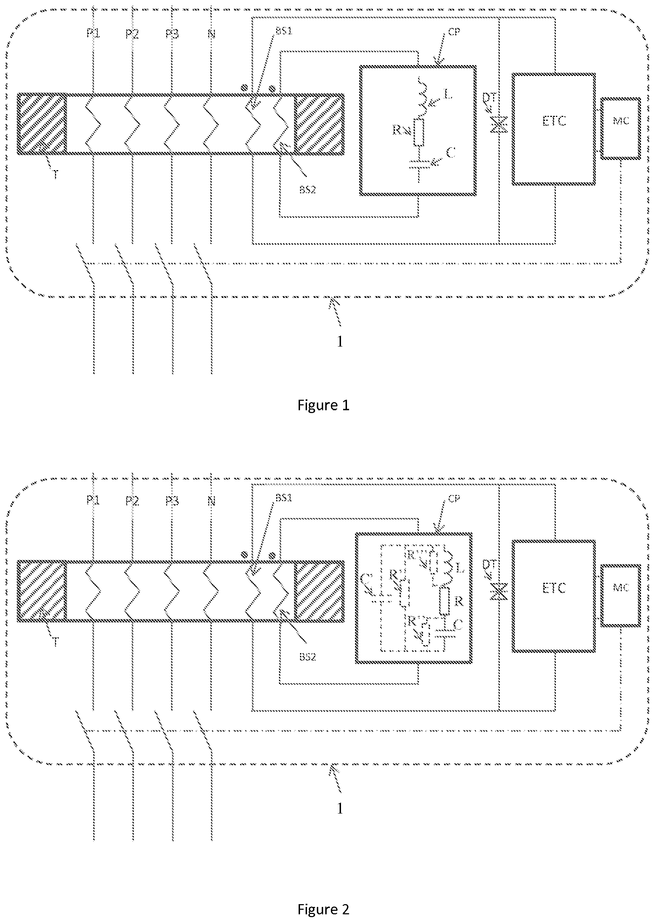

Les figures 1 à 3 montrent toutes un dispositif de protection différentielle permettant la détection de courant de fuite ou de défaut dans une installation électrique alimentée par au moins un conducteur de phase P1, P2, P3 d'un réseau et au moins un conducteur de neutre et/ou de terre N dudit réseau.

Ledit dispositif 1 comprend, d'une part, un transformateur avec un noyau, préférentiellement torique, en matériau ferromagnétique T, avec un primaire constitué par au moins deux des conducteurs P1, P2, P3, N précités et avec au moins un bobinage secondaire BS1, BS2 aux bornes duquel, ou de chacun desquels, s'établit un signal induit lors de l'apparition d'un défaut différentiel au niveau du primaire, et d'autre part, au moins un circuit de traitement et de commande ETC adapté pour traiter le signal induit et pour, en cas de dépassement d'une valeur de seuil prédéfinie, commander un actionneur électromagnétique, un relais ou un moyen de coupure ou d'ouverture analogue MC du dispositif 1, le(s)dit(s) circuit(s) ETC étant relié(s) aux bornes du ou des bobinages(s) secondaire(s) BS1, BS2 considéré(s).

Conformément à l'invention, il est prévu
que le transformateur T comporte deux bobinages secondaires BS1 et BS2 distincts et séparés, faisant partie de deux circuits électriques mutuellement indépendants,
que le circuit de traitement et de commande ETC est relié aux bornes d'un premier bobinage secondaire BS1, et
qu'un circuit passif CP comprenant une inductance L au moins, ainsi qu'au moins une résistance R et/ou au moins un condensateur C en série, est relié aux bornes du second bobinage secondaire BS2.

Grâce aux dispositions techniques ci-dessus, l'invention permet de fournir un dispositif 1 qui est moins sensible aux capacités parasites (fréquence de coupure plus élevée, seules des pertes dans le tore T subsistent), qui permet de fournir un plateau pour des fréquences élevées, notamment supérieures à 100 kHz (l'inductance L compense les pertes du tore T) et qui permet de bien séparer le problème basse-fréquence et haute-fréquence.

Selon une première caractéristique de l'invention, il est profitablement prévu que le premier bobinage BS1 présente un nombre de spires supérieur, préférentiellement nettement supérieur, c'est-à-dire au moins 2 fois supérieur à celui du second bobinage secondaire BS2, les sens d'enroulement des deux bobinages BS1 et BS2 précités étant identiques.

Ainsi, l'inductance du tore T vue par le circuit passif CP est fortement diminuée.

Avantageusement, l'inductance L faisant partie du circuit passif CP est dimensionnée de telle manière que, pour des fréquences de courant de défaut supérieures à environ 20 kHz, le seuil de déclenchement du circuit ETC est inférieur ou égal à 420 mA, préférentiellement au plus égal à 300 mA.

Outre le fait d'étendre la sécurité normative pour la protection des personnes et la protection contre les incendies au-delà de 20kHz, préférentiellement au-delà de 100kHz, la mise en oeuvre d'une inductance L dimensionnée comme indiqué ci-dessus entraîne un renforcement de la sécurité (seuil de déclenchement plus bas) et permet simultanément de pouvoir corriger les défauts liés aux facteurs parasites de certains composants du dispositif 1, comme par exemple les capacités parasites des diodes transil DT, qui sont montées directement en parallèle de l'un au moins des enroulements secondaires BS1, BS2.

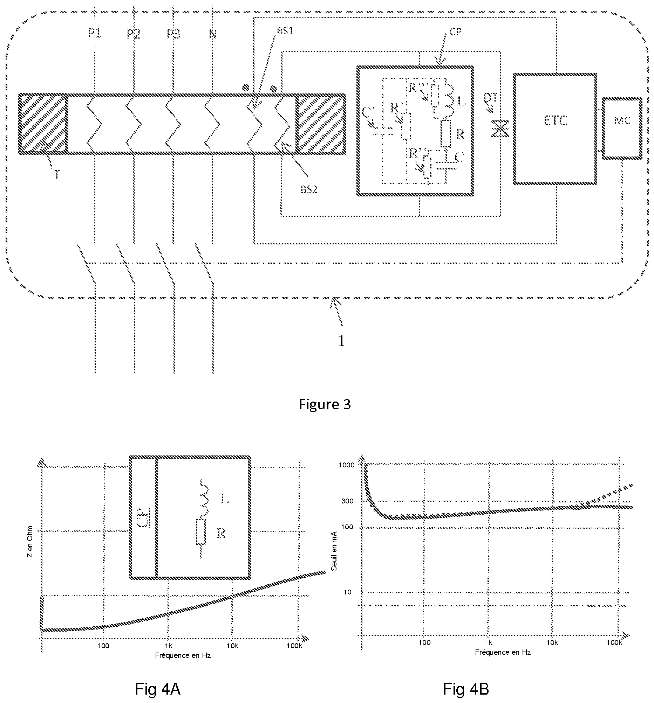

Selon une première variante de réalisation, le circuit passif CP comprend également au moins une résistance R, montée en série avec l'inductance L. Comme le montre la représentation en insert de la figure 4A, le circuit CP peut alors, le cas échéant, se limiter à un simple circuit LR série.

Préférentiellement, la valeur de la résistance R est dimensionnée de telle manière que, pour des fréquences de courant de défaut supérieures à 20 kHz environ, le seuil de déclenchement du circuit ETC est inférieur ou égal à 420 mA, préférentiellement au plus égal à 300 mA.

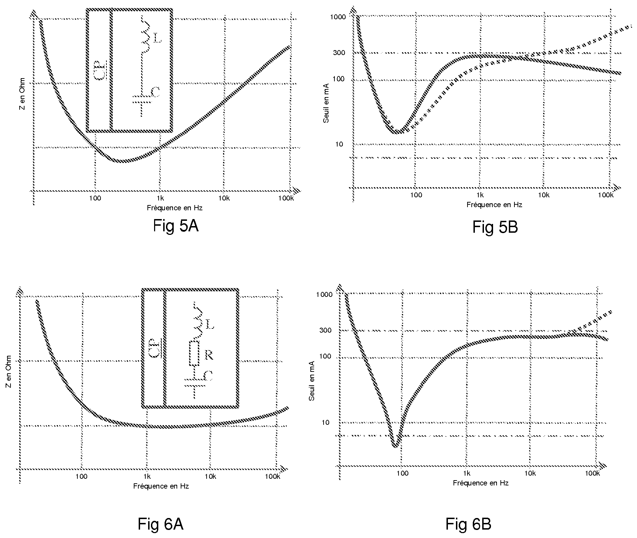

Selon une seconde variante de réalisation, alternative ou cumulative avec la première variante précitée, le circuit passif CP comprend également au moins un condensateur C monté en série avec l'inductance L. Comme le montre la représentation en insert de la figure 5A, le circuit CP peut alors, le cas échéant, se limiter à un simple circuit LC série.

Préférentiellement, la capacité du condensateur C est dimensionnée de telle manière que, pour des fréquences de courant de défaut inférieures à environ 1 kHz, le seuil de déclenchement du circuit ETC est inférieur ou égal à 420 mA, préférentiellement au plus égal à 300 mA (ce condensateur C permet de régler le seuil de déclenchement à IDN pour une fréquence < 1000 Hz).

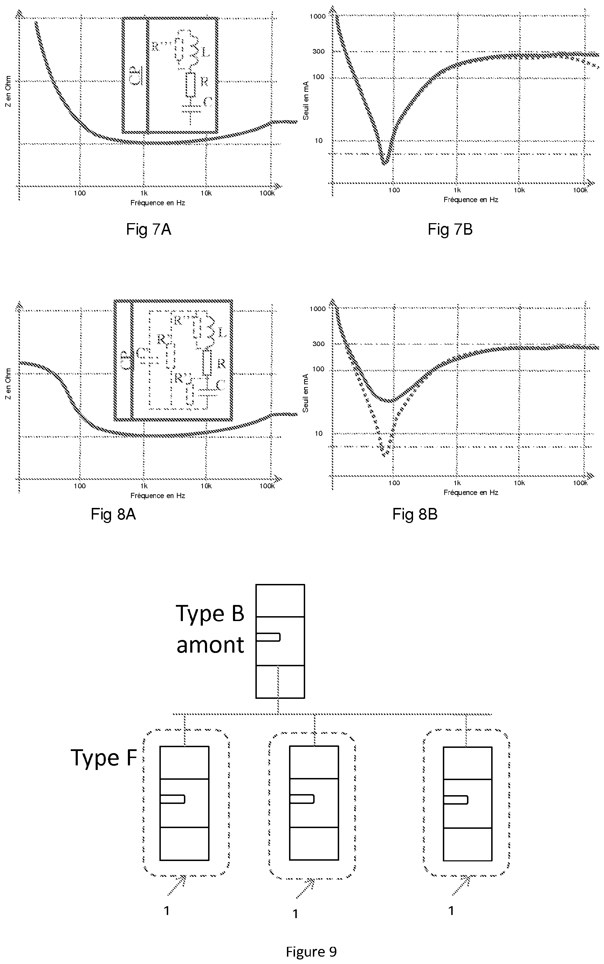

En accord avec un mode de réalisation extrêmement préféré de l'invention, et comme cela ressort des figures 1 à 3, et 6A à 8A, le circuit passif CP comprend au moins un circuit RLC série (éventuellement juste un tel circuit - cf. figures 1 et 6A), les différents composants R, L et C dudit circuit étant dimensionnés de telle manière que le seuil de déclenchement du circuit ETC soit inférieur à 420 mA, préférentiellement inférieur ou égal à 300 mA, pour des fréquences du courant de défaut comprises entre 0 Hz et 50 kHz au moins, préférentiellement entre 0 Hz et 100 kHz au moins.

Grâce aux configurations et aux dimensionnements des composants R, L et C mentionnés dans les variantes et modes de réalisations précités, l'invention permet de respecter simultanément les contraintes de limite de courant fixées par le standard IEC479-2 (risques de fibrillation cardiaque), ainsi que les contraintes de limite de courant stipulées dans le standard IEC60364-4-42 et les directives 3501 VDS (risques d'emballement thermique).

Pour les constructions représentées sur les figures, et lorsque BS1 = BS2 en termes de nombre de spires, les valeurs des composants du circuit RLC peuvent être choisis comme suit : R compris entre 2000 ohms et 7000 ohms ; L compris entre 1 mH et 10 mH ; C compris entre 20 nf et 80 nf.

Alternativement, et lorsque BS1 (ETC) >> BS2 (CP) en termes de nombre de spires, les valeurs des composants peuvent s'établir comme suit : 200 ohms <_ R ≤ 700 ohms ; 200 nf ≤ C <_ 800 nf ; 0,01 mH < L < 1 mH (cette faible valeur d'inductance permet de réduire la taille de la bobine d'inductance et son encombrement sur le circuit physique).

Comme évoqué ci-dessous un ou plusieurs autres composants passifs peuvent être associés aux composants L et R et/ou C précités.

Comme le montrent les figures 2 et 3, il peut être prévu qu'une résistance R' soit montée en parallèle aux bornes du circuit passif CP. Une telle résistance supplémentaire R' (par exemple comprise entre 0,1 Mohms et 1,0 Mohms) permet de fixer l'impédance aux basses fréquences et la réalisation de dispositifs 1 avec des sensibilités différentes (100 mA, 300 mA, 420 mA, ...) tout en utilisant le même tore T.

Alternativement ou simultanément, il peut aussi être prévu qu'une résistance R" soit montée en parallèle aux bornes du condensateur C du circuit passif CP (figures 2, 3 et 8A). Une telle résistance additionnelle R" (par exemple compris entre 10 kohms et 1 Mohms) permet de fixer un palier supplémentaire limitant l'influence de C et de fixer un autre seuil de déclenchement en basse fréquence. L'influence de R" au niveau du circuit CP est sensiblement équivalente à celle de R'.

Selon une autre caractéristique possible de l'invention, un condensateur C' peut être monté en parallèle aux bornes du circuit passif CP (figures 2, 3 et 8A). Ce condensateur C' (par exemple de quelques pF) peut réaliser un filtrage des fréquences au-delà d'une certaine valeur, par exemple au-delà d'environ 100 kHz.

Les composants C' et R' montés aux bornes du circuit passif CP, peuvent faire constructivement partie de ce dernier (cf. figures 1 à 5).

Enfin, il peut également être envisagé, comme le montrent aussi les figures 2, 3, 7 et 8A à titre d'exemple, qu'une résistance supplémentaire R‴ soit montée en parallèle sur l'inductance L du circuit passif CP (avec par exemple R‴ compris entre 1 kohms et 1 Mohms). Une telle résistance R‴ permet de limiter l'effet de l'inductance L à partir d'une fréquence du courant de défaut supérieure à 100 kHz.

Afin d'éviter les déclenchements intempestifs du dispositif 1 lors de courants élevés du type foudre et surtout de protéger les composants électroniques du circuit ETC, le dispositif 1 peut comprendre, en outre, une diode transil DT qui est montée en parallèle sur le circuit de traitement et de commande ETC ou sur le circuit passif CP et reliée aux bornes de l'un des deux bobinages secondaires BS1 et BS2.En connectant la diode transil DT aux bornes opposées du bobinage BS1 de plus grande dimension, il est possible de sélectionner une diode DT avec une tension plus élevée et de ce fait diminuer la valeur de la capacité parasite de celle-ci (qui dépend de sa tension).

L'invention a également pour objet un dispositif différentiel de type F ou de type B, caractérisé en ce qu'il intègre un dispositif 1 tel que décrit ci-dessus.

Enfin, l'invention concerne également, comme le montre la figure 11, un arrangement de dispositifs différentiels à deux niveaux, comprenant un dispositif différentiel de type B, de nature électromécanique et électronique, en amont et plusieurs dispositifs différentiels de type F, de nature exclusivement électromécanique, en aval, cet arrangement étant caractérisé en ce que les dispositifs de type F correspondent chacun à un dispositif 1 tel que mentionné ci-dessus (les dispositifs de type F visés dans la présente sont compatibles avec le dispositif amont de type B, et acceptent la valeur de courant continu de ce dernier, les deux fonctions étant indépendantes).

Bien entendu, l'invention n'est pas limitée aux modes de réalisation décrits et représentés aux dessins annexés. Des modifications restent possibles, notamment du point de vue de la constitution des divers éléments ou par substitution d'équivalents techniques, sans sortir pour autant du domaine de protection de l'invention, tel que défini dans les revendications annexées.

## Revendications

1. Dispositif (1) de protection différentielle permettant la détection de courant de fuite ou de défaut dans une installation électrique alimentée par au moins un conducteur de phase (P1, P2, P3) d'un réseau et au moins un conducteur de neutre et/ou de terre (N) dudit réseau,
ledit dispositif (1) comprenant, d'une part, un transformateur avec un noyau, préférentiellement torique, en matériau ferromagnétique (T), avec un primaire constitué par au moins deux des conducteurs (P1, P2, P3, N) précités et avec au moins un bobinage secondaire (BS1, BS2) aux bornes duquel, ou de chacun desquels, s'établit un signal induit lors de l'apparition d'un défaut différentiel au niveau du primaire et, d'autre part, au moins un circuit de traitement et de commande (ETC) adapté pour traiter le signal induit et pour, en cas de dépassement d'une valeur de seuil prédéfinie, commander un actionneur électromagnétique, un relais ou un moyen de coupure ou d'ouverture analogue (MC) du dispositif (1), le(s)dit(s) circuit(s) (ETC) étant relié(s) aux bornes dudit au moins un bobinage secondaire (BS 1, BS2),
dispositif de protection différentielle (1) **caractérisé**
**en ce que** le transformateur (T) comporte deux bobinages secondaires (BS1 et BS2) distincts, faisant partie de deux circuits électriques mutuellement indépendants,
**en ce que** le circuit de traitement et de commande (ETC) est relié aux bornes d'un premier bobinage secondaire (BS1), et
**en ce qu'**un circuit passif (CP) comprenant une inductance (L) au moins, ainsi qu'au moins une résistance (R) et/ou au moins un condensateur (C) monté(e)(s) en série avec ladite au moins une inductance (L), est relié aux bornes du second bobinage secondaire (BS2),
l'inductance (L) faisant partie du circuit passif (CP) étant dimensionnée de telle manière que, pour des fréquences de courant de défaut supérieures à environ 20 kHz, le seuil de déclenchement du circuit (ETC) est inférieur ou égal à 420 mA.

2. Dispositif de protection différentielle selon la revendication 1, **caractérisé en ce que** le circuit passif (CP) comprend au moins un circuit RLC série, les différents composants (R, L et C) dudit circuit étant dimensionnés de telle manière que le seuil de déclenchement du circuit (ETC) est inférieur à 420 mA, pour des fréquences du courant de défaut comprises entre 0 Hz et 50 kHz au moins, préférentiellement comprises entre 0 Hz et 100 kHz.

3. Dispositif de protection différentielle selon l'une quelconque des revendications 1 à 2, **caractérisé en ce que** le seuil de déclenchement du circuit (ETC) est inférieur ou égal à 300 mA.

4. Dispositif de protection différentielle selon l'une quelconque des revendications 1 à 3, **caractérisé en ce qu'**une résistance (R') est montée en parallèle aux bornes du circuit passif (CP).

5. Dispositif de protection différentielle selon l'une quelconque des revendications 1 à 3, **caractérisé en ce qu'**une résistance (R") est montée en parallèle aux bornes du condensateur (C) du circuit passif (CP).

6. Dispositif de protection différentielle selon l'une quelconque des revendications 1 à 5, **caractérisé en ce qu'**une résistance (R‴) est montée en parallèle sur l'inductance (L) du circuit passif (CP).

7. Dispositif de protection différentielle selon l'une quelconque des revendications 1 à 6, **caractérisé en ce qu'**un condensateur (C') est monté en parallèle aux bornes du circuit passif (CP).

8. Dispositif de protection différentielle selon l'une quelconque des revendications 1 à 7, **caractérisé en ce qu'**il comprend, en outre, une diode transil (DT) qui est montée en parallèle sur le circuit de traitement et de commande (ETC) ou sur le circuit passif (CP), et reliée aux bornes de l'un des deux bobinages secondaires (BS1, BS2).

9. Dispositif de protection différentielle selon l'une quelconque des revendications 1 à 8, **caractérisé en ce que** le premier bobinage (BS1) présente un nombre de spires supérieur, préférentiellement au moins 2 fois supérieur à celui du second bobinage secondaire (BS2), les sens d'enroulement des deux bobinages (BS1 et BS2) précités étant identiques.

10. Dispositif différentiel de type F ou de type B, **caractérisé en ce qu'**il intègre un dispositif selon l'une quelconque des revendications 1 à 9.

11. Arrangement de dispositifs différentiels à deux niveaux, comprenant un dispositif différentiel de type B, de nature électromécanique et électronique, en amont et plusieurs dispositifs différentiels de type F, de nature exclusivement électromécanique, en aval, arrangement **caractérisé en ce que** les dispositifs de type F correspondent chacun à un dispositif selon l'une quelconque des revendications 1 à 9.

## Patentansprüche

1. Differentialschutzvorrichtung (1), die die Erkennung von Leck- oder Fehlerstrom in einer von mindestens einem Phasenleiter (P1, P2, P3) eines Netzes und mindestens einem Neutral- und/oder Erdleiter (N) des Netzes gespeisten elektrischen Anlage ermöglicht,
wobei die Vorrichtung (1) einerseits einen Transformator, vorzugsweise mit einem Ringkern aus ferromagnetischem Material (T), mit einer Primärwicklung bestehend aus mindestens zwei der oben genannten Leiter (P1, P2, P3, N) und mit mindestens einer Sekundärwicklung (BS1, BS2), an deren Klemmen oder den Klemmen jeder von ihnen sich ein Signal aufbaut, das beim Auftreten eines Differentialfehlers im Bereich der Primärwicklung induziert wird, und andererseits mindestens eine Verarbeitungs- und Steuerschaltung (ETC) enthält, die geeignet ist, das induzierte Signal zu verarbeiten und im Fall des Überschreitens eines vordefinierten Schwellwerts ein elektromagnetisches Stellglied, ein Relais oder eine Unterbrechungs- oder analoge Öffnungseinrichtung (MC) der Vorrichtung (1) zu steuern, wobei die Schaltung(en) (ETC) mit den Klemmen der mindestens einen Sekundärwicklung (BS1, BS2) verbunden ist(sind),
wobei die Differentialschutzvorrichtung (1) **dadurch gekennzeichnet ist,**
**dass** der Transformator (T) zwei getrennte Sekundärwicklungen (BS1 und BS2) aufweist, die Teil von zwei voneinander unabhängigen elektrischen Schaltungen sind,
**dass** die Verarbeitungs- und Steuerschaltung (ETC) mit den Klemmen einer ersten Sekundärwicklung (BS1) verbunden ist, und
**dass** eine passive Schaltung (CP), die mindestens eine Induktivität (L) sowie mindestens einen Widerstand (R) und/oder mindestens einen Kondensator (C) enthält, die(der) mit der mindestens einen Induktivität (L) in Reihe eingebaut ist(sind), mit den Klemmen der zweiten Sekundärwicklung (BS2) verbunden ist,
wobei die Induktivität (L), die Teil der passiven Schaltung (CP) ist, so bemessen ist, dass für Fehlerstromfrequenzen höher als etwa 20 kHz die Auslöseschwelle der Schaltung (ETC) niedriger als oder gleich 420 mA ist.

2. Differentialschutzvorrichtung nach Anspruch 1, **dadurch gekennzeichnet, dass** die passive Schaltung (CP) mindestens eine RLC-Reihenschaltung enthält, wobei die verschiedenen Komponenten (R, L und C) der Schaltung so bemessen sind, dass die Auslöseschwelle der Schaltung (ETC) für Frequenzen des Fehlerstroms zwischen 0 Hz und mindestens 50 kHz, vorzugsweise zwischen 0 Hz und 100 kHz, niedriger ist als 420 mA.

3. Differentialschutzvorrichtung nach einem der Ansprüche 1 bis 2, **dadurch gekennzeichnet, dass** die Auslöseschwelle der Schaltung (ETC) niedriger als oder gleich 300 mA ist.

4. Differentialschutzvorrichtung nach einem der Ansprüche 1 bis 3, **dadurch gekennzeichnet, dass** ein Widerstand (R') parallel zu den Klemmen der passiven Schaltung (CP) eingebaut ist.

5. Differentialschutzvorrichtung nach einem der Ansprüche 1 bis 3, **dadurch gekennzeichnet, dass** ein Widerstand (R") parallel zu den Klemmen des Kondensators (C) der passiven Schaltung (CP) eingebaut ist.

6. Differentialschutzvorrichtung nach einem der Ansprüche 1 bis 5, **dadurch gekennzeichnet, dass** ein Widerstand (R"') parallel auf die Induktivität (L) der passiven Schaltung (CP) eingebaut ist.

7. Differentialschutzvorrichtung nach einem der Ansprüche 1 bis 6, **dadurch gekennzeichnet, dass** ein Kondensator (C') parallel zu den Klemmen der passiven Schaltung (CP) eingebaut ist.

8. Differentialschutzvorrichtung nach einem der Ansprüche 1 bis 7, **dadurch gekennzeichnet, dass** sie außerdem eine Transildiode (DT) enthält, die parallel auf die Verarbeitungs- und Steuerschaltung (ETC) oder auf die passive Schaltung (CP) eingebaut und mit den Klemmen einer der zwei Sekundärwicklungen (BS1, BS2) verbunden ist.

9. Differentialschutzvorrichtung nach einem der Ansprüche 1 bis 8, **dadurch gekennzeichnet, dass** die erste Wicklung (BS1) eine höhere Anzahl, vorzugsweise mindestens doppelt so hohe Anzahl von Windungen wie diejenige der zweiten Sekundärwicklung (BS2) aufweist, wobei die Wicklungsrichtungen der zwei genannten Wicklungen (BS1 und BS2) gleich sind.

10. Differentialvorrichtung vom Typ F oder vom Typ B, **dadurch gekennzeichnet, dass** sie eine Vorrichtung nach einem der Ansprüche 1 bis 9 umfasst.

11. Anordnung von Differentialvorrichtungen in zwei Ebenen, die eine vorgeschaltete Differentialvorrichtung vom Typ B von elektromechanischer und elektronischer Beschaffenheit und mehrere nachgeschaltete Differentialvorrichtungen vom Typ F von ausschließlich elektromechanischer Beschaffenheit enthält, wobei die Anordnung **dadurch gekennzeichnet ist, dass** die Vorrichtungen vom Typ F je einer Vorrichtung nach einem der Ansprüche 1 bis 9 entsprechen.

## Claims

1. Differential protection device (1) for detecting leakage current or fault current in an electrical installation powered by at least one phase conductor (P1, P2, P3) of a network and at least one neutral and/or earth conductor (N) of said network,
said device (1) comprising, on the one hand, a transformer with a preferentially toroidal core made of ferromagnetic material (T), with a primary winding composed of at least two of the aforementioned conductors (P1, P2, P3, N) and with at least one secondary winding (BS1, BS2) across the terminals of which, or each of which, is established a signal induced when a differential fault occurs at the primary winding and, on the other hand, at least one processing and control circuit (ETC) designed to process the induced signal and, in the event that a predefined threshold value is exceeded, to control an electromagnetic actuator, a relay or an analogue means (MC) for disconnecting or opening the device (1), said circuit(s) (ETC) being connected to the terminals of said at least one secondary winding (BS1, BS2),
the differential protection device (1) being **characterized**
**in that** the transformer (T) comprises two separate secondary windings (BS1 and BS2) which form part of two mutually independent electrical circuits,
**in that** the processing and control circuit (ETC) is connected to the terminals of a first secondary winding (BS1), and
**in that** a passive circuit (CP) comprising one inductor (L) at least, and at least one resistor (R) and/or at least one capacitor (C) connected in series with said at least one inductor (L), is connected to the terminals of the second secondary winding (BS2),
the inductor (L) that forms part of the passive circuit (CP) being dimensioned in such a way that, for fault current frequencies greater than approximately 20 kHz, the triggering threshold of the circuit (ETC) is less than or equal to 420 mA.

2. Differential protection device according to Claim 1, **characterized in that** the passive circuit (CP) comprises at least one series RLC circuit, the various components (R, L and C) of said circuit being dimensioned in such a way that the triggering threshold of the circuit (ETC) is less than 420 mA, for fault current frequencies between 0 Hz and 50 kHz at least, preferentially between 0 Hz and 100 kHz.

3. Differential protection device according to either of Claims 1 and 2, **characterized in that** the triggering threshold of the circuit (ETC) is less than or equal to 300 mA.

4. Differential protection device according to any one of Claims 1 to 3, **characterized in that** a resistor (R') is connected in parallel across the terminals of the passive circuit (CP).

5. Differential protection device according to any one of Claims 1 to 3, **characterized in that** a resistor (R") is connected in parallel across the terminals of the capacitor (C) of the passive circuit (CP).

6. Differential protection device according to any one of Claims 1 to 5, **characterized in that** a resistor (R‴) is connected in parallel with the inductor (L) of the passive circuit (CP).

7. Differential protection device according to any one of Claims 1 to 6, **characterized in that** a capacitor (C') is connected in parallel across the terminals of the passive circuit (CP).

8. Differential protection device according to any one of Claims 1 to 7, **characterized in that** it further comprises a transil diode (DT) which is connected in parallel with the processing and control circuit (ETC) or with the passive circuit (CP), and connected to the terminals of one of the two secondary windings (BS1, BS2) .

9. Differential protection device according to any one of Claims 1 to 8, **characterized in that** the first winding (BS1) has a number of turns which is greater, preferentially at least two times greater, than that of the second secondary winding (BS2), the winding directions of the two aforementioned windings (BS1 and BS2) being identical.

10. F-type or B-type differential device, **characterized in that** it incorporates a device according to any one of Claims 1 to 9.

11. Two-tier arrangement of differential devices, comprising a B-type differential device, of electromechanical and electronic nature, upstream and a plurality of F-type differential devices, exclusively of electromechanical nature, downstream, the arrangement being **characterized in that** the F-type devices each correspond to a device according to any one of Claims 1 to 9.
